Europäisches Patentamt

European Patent Office

Office européen des brevets

(11) Veröffentlichungsnummer: **0 312 715**
**A1**

## EUROPÄISCHE PATENTANMELDUNG

(21) Anmeldenummer: 88112303.8

(22) Anmeldetag: 29.07.88

(51) Int. Cl.4: **G01R 19/165 , G01R 19/25 , H03F 3/45**

(30) Priorität: 18.09.87 DE 3731535

(43) Veröffentlichungstag der Anmeldung:
26.04.89 Patentblatt 89/17

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Luschnig, Werner, Dipl.-Ing.**
**Rudolfweg 32**
**A-9524 St. Magdalen(AT)**

(54) **Schaltungsanordnung zur Bestimmung der Leistung eines frequenzbandbegrenzten periodischen Signals.**

(57) Schaltungsanordnung zur Leistungsbestimmung eines frequenzbandbegrenzten periodischen Signals mit einem Absolutspannungswert-Komparator (12), einer Abtastschaltung (14) zur Abtastung des Komparator-Ausgangssignals und einem die Abtastwerte zählenden Zähler (16).

FIG1

**Schaltungsanordnung zur Bestimmung der Leistung eines frequenzbandbegrenzten periodischen Signals**

Die vorliegende Erfindung betrifft eine Schaltungsanordnung zur Bestimmung der Leistung eines frequenzbandbegrenzten periodischen Signals.

Eine Möglichkeit einer Informationscodierung besteht darin, die beiden möglichen logischen Werte der Informations-Bits (0 und 1) durch ein bandbegrenztes periodisches Signal zu realisieren. Das ist beispielsweise dadurch möglich, daß die beiden logischen Werte durch eine bestimmte Anzahl von Perioden zweier periodischer Signale mit unterschiedlichen Frequenzen gebildet wird, wobei die Zeitperiode, welche durch die Anzahl von Perioden der beiden periodischen Signale unterschiedlicher Frequenzen gebildet wird, immer gleich ist, und wobei ein phasenkontinuierlicher Übergang zwischen den beiden Signalen unterschiedlicher Frequenzen vorhanden ist. Eine weitere Möglichkeit besteht darin, in jeweils der gleichen Zeitperiode zwei Halbwellen bzw. eine Halbwelle jeweils eines periodischen Signals unterzubringen, wobei es sich um ein phasenkohärentes Verfahren handelt. In beiden Fällen ist die Frequenzbandbegrenzung durch die immer gleiche Zeitperiode gegeben, in der jeweils ein logischer Wert codiert ist.

Codierungsverfahren der vorgenannten Art kommen beispielsweise in der digitalen Fernsprechtechnik zur Anwendung. Dabei kann eine Abschätzung erforderlich werden, ob ein bandbegrenztes Signal der genannten Art eine größere oder eine kleinere Leistung als ein bestimmter Wert hat. Eine Möglichkeit, eine derartige Abschätzung durchzuführen, besteht in der Verwendung von in diskreter Schaltungstechnik aufgebauten Analogfiltern mit Bandpässen und Integratoren. Dabei muß jedoch eine große Anzahl von Bauelementekomponenten verwendet werden, welche in integrierter Halbleiterschaltungstechnik nicht realisierbar sind. In einer integrierten Lösung ist daher eine Anzahl der für den Betrieb erforderlichen passiven Bauelemente extern an einen integrierten Schaltkreis anzuschalten. Andererseits ist man jedoch in integrierter Schaltungstechnik bemüht, die Anzahl der extern an integrierte Schaltkreise anzuschaltenden Bauelementekomponenten möglichst gering zu halten.

Weiterhin ist die Realisierung bestimmter nichtlinearer und unstetiger Kennlinien bei analogen Lösungen gegenüber digitalen Lösungen mit großem Aufwand verbunden.

Der vorliegenden Erfindung liegt die Aufgabe zugrunde, eine Schaltungsanordnung der in Rede stehenden Art anzugeben, die in integrierter Halbleiterschaltungstechnik mit einer geringstmöglichen Anzahl von extern zuzuschaltenden Bauelementekomponente bei geringem Gesamtaufwand auskommt.

Diese Aufgabe wird bei einer Schaltungsanordnung der eingangs genannten Art erfindungsgemäß durch die Merkmale des kennzeichnenden Teils des Patentanspruches 1 gelöst.

Weiterbildungen der Erfindung sind Gegenstand von Unteransprüchen.

Die Erfindung wird im folgenden anhand von in den FIG der Zeichnung dargestellten Ausführungsbeispielen näher erläutert.

Es zeigt:

FIG 1 ein generelles Blockschaltbild einer erfindungsgemäßen Schaltungsanordnung;

FIG 2 eine Ausführungsform eines Absolutspannungswert-Komparators der Schaltungsanordnung nach FIG 1;

FIG 3 ein detailliertes Schaltbild einer Ausführungsform eines Absolutspannungswert-Komparators; und

FIG 4 Signaldiagramme zur Erläuterung der Wirkungsweise des Absolutspannungswert-Komparators nach FIG 3.

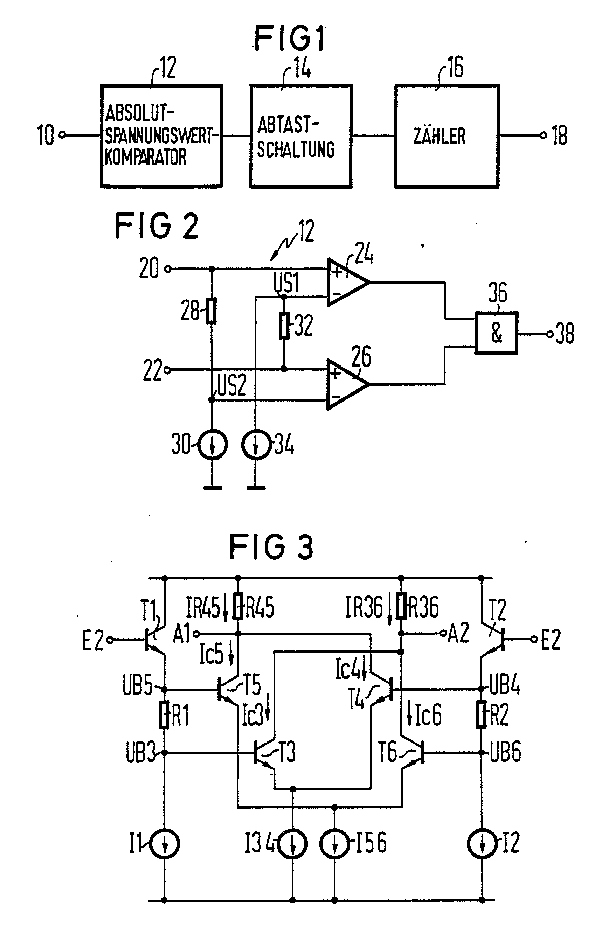

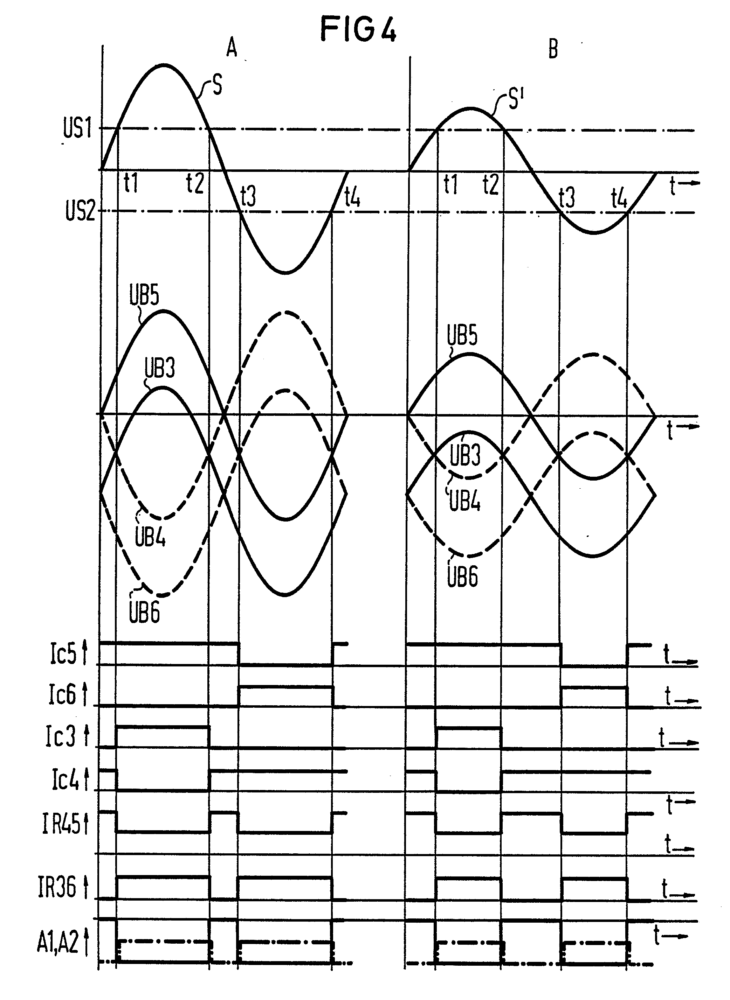

Das Blockschaltbild nach FIG 1 zeigt den grundsätzlichen Aufbau einer erfindungsgemäßen Schaltungsanordnung zur Bestimmung der Leistung eines frequenzbandbegrenzten periodischen Signals. In dieser Schaltungsanordnung wird an einem Eingang 10 das periodische Signal eingespeist, dessen Leistung bestimmt werden soll. Ein Absolutspannungswert-Komparator 12 stellt fest, ob der Absolutspannungswert des Eingangssignals größer oder kleiner als eine vorgegebene Schwelle ist. Wie im folgenden anhand der Signaldiagrammfolge nach FIG 4 im einzelnen noch erläutert wird, liefert der Absolutspannungswert-Komparator 12 mindestens ein impulsförmiges Ausgangssignal, dessen Impuls-Pausen-Verhältnis eine Funktion der Amplitude des periodischen Eingangssignals ist.

In einer dem Absolutspannungswert-Komparator 12 nachgeschalteten Abtastschaltung 14, die in an sich bekannter Weise als Abtast- und Halteschaltung ausgebildet sein kann, wird das Ausgangssignal des Absolutspannungswert-Komparators 12 abgetastet, so daß die Abtastschaltung 14 ein Digitalsignal liefert, das in einen Zähler 16 eingespeist wird. Da der Aufbau der Abtastschaltung an sich bekannt ist, wird diese hier nicht näher erläutert.

Der Zähler 16 stellt in einer vorgegebenen Periode, insbesondere während wenigstens einer Signalperiode, fest, wieviel Abtastwerte im Ausgangssignal der Abtastschaltung 14 einen hohen oder tiefen logischen Wert besitzen. Das Ergebnis ergibt beispielsweise über das höchstwertige Bit im Ausgangssignal des Zählers 16 an einem Ausgang 18 eine statistische Aussage über die in der Meßperiode aufgetretenen Amplituden des periodischen Eingangssignals in bezug auf die Spannungsquelle. Ist bekannt, auf welche Last das periodische Signal am Eingang 10 arbeitet, so kann über das Ausgangssignal des Zählers 16 am Ausgang 18 auf die Signalleistung rückgeschlossen werden.

FIG 2 zeigt eine Ausführungsform des Absolutspannungswert-Komparators 12 nach FIG 1. Bei dieser Ausführungsform sind zwei Differenzverstärker 24 und 26 vorgesehen, die über einen Eingang 20 bzw. einen Eingang 22 an ihrem nichtinvertierenden Eingang + das periodische Signal in seiner Normalphasenlage bzw. komplementär - gegenüber der Normalphasenlage invertiert - erhalten. An invertierenden Eingängen - der Differenzverstärker 24 und 26 wird jeweils über einen Kreis aus einem Widerstand 28 und einer Stromquelle 30 bzw. einem Widerstand 32 und einer Stromquelle 34 eine Spannungsschwelle US1 bzw. US2 eingestellt. Die Spannungsschwellen-Einstellkreise 28,30 bzw. 32,34 liegen dabei mit einem Anschluß ihres Widerstandes 28 bzw. 32 am Eingang 20 bzw. 22, während der invertierende Eingang - des Differenzverstärkers 24 bzw. 26 jeweils am Verbindungspunkt des Widerstandes 28 bzw. 32 und der Stromquelle 30 bzw. 34 liegt. Zur Darstellung des periodischen Signals in bezug auf die Spannungsschwellen US1,US2 wird auf das jeweils obere Signaldiagramm der Signalfolgen A und B nach FIG 4 Bezug genommen, worin ein periodisches Eingangssignal S bzw. S' für zwei unterschiedlich große Amplituden in bezug auf die Spannungsschwellen US1 bzw. US2 dargestellt ist.

Die Ausgänge der Differenzverstärker 24,26 sind auf eine Und-Verknüpfung in Form eines Und-Gatters 36 geführt, dessen Ausgang 38 dem Ausgang des an die Abtastschaltung 14 angekoppelten Absolutspannungswert-Komparators 12 nach FIG 1 entspricht.

Eine detaillierte schaltungstechnische Ausführungsform eines Absolutspannungswert-Komparators ist in FIG 3 dargestellt. In diesem Komparator sind wiederum zwei Differenzverstärker vorgesehen, welche durch Transistorstufen T3,T4 sowie T5,T6 gebildet werden. Die Transistorpaare T3,T4 sowie T5,T6 sind jeweils emittergekoppelt und über eine Stromquelle I34 sowie I56 an Bezugspotential gekoppelt. Im Kollektorzweig jeweils einer Transistorstufe T3 bzw. T5 liegt ein Lastwiderstand R36 bzw. R45. Die Schaltung ist dabei speziell so ausgeführt, daß der Kollektorzweig der jeweils anderen Transistorstufe T4 bzw. T6 ebenfalls an den Lastwiderstand R45 bzw. R36 angeschlossen ist. Die Verbindungspunkte der Kollektorzweige der Transistorstufen sowie der Lastwiderstände im vorstehend beschriebenen Sinne bilden einen Ausgang A1 bzw. A2 des Absolutspannungswert-Komparators.

Weiterhin sind in der Schaltungsanordnung nach FIG 3 Spannungsschwellen-Einstellkreise vorgesehen, die jeweils durch eine Emitterfolgerstufe mit einem Transistor T1 bzw. T2 sowie einem Widerstand R1 bzww. R2 in deren Emitterzweig sowie einer dazu in Reihe liegenden Stromquelle I1 bzw. I2 gebildet werden. Die Schaltungsanordnung ist weiterhin so ausgebildet, daß jeweils eine Transistorstufe eines Transistorpaares eines Differenzverstärkers direkt an den Emitter des Transistors im Spannungsschwellen-Einstellkreis und die andere Transistorstufe an den Verbindungspunkt von Widerstand und Stromquelle im Spannungsschwellen-Einstellkreis angekoppelt ist. So ist in dem durch das Transistorpaar T5,T6 gebildeten Differenzverstärker die Transistorstufe T5 mit ihrer Basis an den Emitter des Transistors T1 und die Transistorstufe T6 mit ihrer Basis an den Verbindungspunkt des Widerstandes R2 und der Stromquelle I2 angekoppelt. Entsprechend ist in dem durch das Transistorpaar T3,T4 gebildeten Differenzverstärker der Transistor T4 mit seiner Basis an den Emitter des Transistors T2 und die Transistorstufe T3 mit ihrer Basis an den Verbindungspunkt des Widerstandes R1 und der Stromquelle I1 angekoppelt.

Das periodische Eingangssignal wird an einem Eingang E1 an der Basis des Transistors T1 bzw. an einem Eingang E2 an der Basis des Transistors T2 in den Absolutspannungswert-Komparator eingespeist, und zwar derart, daß das periodische Eingangssignal in seiner Normalphasenlage in den Eingang E1 und komplementär - gegenüber der Normalphasenlage invertiert - in den Eingang E2 eingespeist wird.

Die Werte der Widerstände R36 und R45 sind vorzugsweise so gewählt, daß sie sich wie 2:1 verhalten, d.h., der Wert des Widerstandes R36 ist zweimal so groß wie der Wert des Widerstandes R45.

Die Wirkungsweise der Ausführungsform des Absolutspannungswert-Komparators nach FIG 3 wird anhand der Signaldiagrammfolgen A,B nach FIG 4 erläutert.

Es wurde bereits ausgeführt, daß das obere Signaldiagramm in FIG 4 das Eingangssignal S bzw. S' mit zwei unterschiedlichen Amplituden in bezug auf Spannungsschwellen US1 bzw. US2 darstellt. Aufgrund der beiden Spannungsschwellen für beide Halbperioden kann der Absolutwert der Spannung des Eingangssignals erfaßt werden. Aus diesem Diagramm ist ersichtlich, daß sich in Zeitpunkten t1,t2 bzw. t3,t4 Schnittpunkte des Eingangssignals mit der Spannungsschwelle US1 bzw. US2 ergeben.

Das nächste, in der Zeichnung unterhalb liegende Diagramm zeigt die entsprechenden Signal-Spannungsverläufe als Funktion der Zeit an den Eingängen (Basen) der Transistorstufen der Differenzverstärker. Dabei ist die Basisspannung bzw. das Basispotential der Transistorstufe T3 mit UB3, der Transistorstufe T4 mit UB4, der Transistorstufe T5 mit UB5 und der Transistorstufe T6 mit UB6 bezeichnet. Aus den beiden Signaldiagrammen ist ersichtlich, daß die Spannung UB5 mit dem Signal S bzw. S' übereinstimmt, da die Spannung UB5 am Emitter des Transistors T1 steht.

Da das periodische Eingangssignal am Eingang E2 in bezug auf den Eingang E1 komplementär bzw. invertiert zugeführt wird und da die Spannung UB6 am Verbindungspunkt des Widerstandes R2 und der Stromquelle I2 abgenommen wird, erhält die Transistorstufe T6 des aus dem Transistorpaar T5,T6 gebildeten Differenzverstärkers das Eingangssignal um die durch den Widerstand R2 festgelegte Spannungsschwelle versetzt und invertiert. Dies ist im entsprechenden Signaldiagramm durch den gestrichelten, mit UB6 bezeichneten Signalverlauf dargestellt.

Entsprechende Verhältnisse gelten für den durch das Transistorpaar T3,T4 gebildeten Differenzverstärker. Wie nach den vorstehenden Erläuterungen ohne weiteres ersichtlich ist, gelten für diesen Differenzverstärker im Signaldiagramm die Signalverläufe UB3 bzw. UB4.

In den folgenden vier Signaldiagrammen sind jeweils die mit IC3 bis IC6 bezeichneten Kollektorströme der Transistorstufen T3 bis T6 dargestellt. Wie beispielsweise für die Signal- bzw. Spannungsverläufe UB5 und UB6 aus dem entsprechenden Signaldiagramm ersichtlich ist, ist die Spannung UB5 bis zum Zeitpunkt t3 immer größer als die Spannung UB6, so daß in der Zeitperiode von 0 bis t3 in dem durch das Transistorpaar T5,T6 gebildeten Differenzverstärker im Kollektorzweig der Transistorstufe T5 der Kollektorstrom Ic5 fließt, während im Kollektorzweig der Transistorstufe T6 der Kollektorstrom in dieser Zeitperiode zu 0 wird. Da in der Zeitperiode zwischen den Zeitpunkten t3 und t4 die Spannung UB6 größer als die Spannung UB5 ist, fließt in dieser Zeitperiode ein Kollektorstrom Ic6, wobei dann der Kollektorstrom Ic5 zu 0 wird. Wie ohne weiteres ersichtlich, ergeben sich für die Signalverläufe bzw. Signalspannungen UB3 und UB4 entsprechende Verhältnisse mit den Kollektorstromverläufen Ic3 und Ic4, so daß die Entstehung dieser Stromverläufe nicht noch einmal eigens erläutert werden muß.

In den Lastwiderständen R36 und R45 addieren sich nun die Kollektorströme Ic3,Ic6 bzw. Ic4,Ic5. Wie bereits ausgeführt, ist der Wert des Widerstandes R36 vorzugsweise doppelt so groß wie derjenige des Widerstandes R45. Somit ergeben sich Stromverläufe über diese Widerstände, die mit IR36 bzw. IR45 bezeichnet sind. Wegen des genannten Widerstandsverhältnisses ist der Strom IR45 doppelt so groß wie der Strom IR36.

Im letzten Signaldiagramm nach FIG 4 sind die sich durch die Stromverläufe IR36,IR45 am Ausgang A2 bzw. A1 ergebenden Spannungsverläufe dargestellt. Speziell ist die Spannung am Ausgang A2 strichpunktiert dargestellt, während die Spannung am Ausgang A1 ausgezogen dargestellt ist. Aus einem Vergleich der Signalverläufe an A1,A2 für unterschiedliche Signalamplituden nach den Diagrammfolgen A und B ist ersichtlich, daß am Ausgang des Absolutspannungswert-Komparators impulsförmige Ausgangssignale entstehen, deren Impuls-Pausen-Verhältnis von der Signalamplitude abhängig ist. Aus der Abtastung mindestens eines dieser Signalverläufe A1 bzw. A2 durch die Abtastschaltung 14 nach, FIG 1 ergibt sich daher jedesmal ein bestimmtes Verhältnis von hohen und tiefen logischen Werten, je nachdem, wie das Impuls-Pausen-Verhältnis der Ausgangssignale beschaffen ist. Durch Ermittlung der Anzahl mindestens eines dieser logischen Pegel kann in bereits erläuterter Weise auf die Leistung des periodischen Eingangssignals geschlossen werden.

**Ansprüche**

1. Schaltungsanordnung zur Bestimmung der Leistung eines frequenzbandbegrenzten periodischen Signals,
**gekennzeichnet durch**
einen den Absolutspannungswert des Signals mit einer vorgegebenen Spannungsschwelle vergleichenden Komparator (12), dessen Ausgangssignal angibt, ob der Absolutspannungswert des Signals größer oder kleiner als die vorgegebene Spannungsschwelle ist,
eine dem Absolutspannungswert-Komparator (12) nachgeschaltete Abtastschaltung (14), welche das Ausgangssignal des Absolutspannungswert-Komparators (12) pro Signalperiode vorgegeben oft abtastet,
und einen der Abtastschaltung (14) nachgeschalteten Zähler (16), der die Anzahl einer der beiden während wenigstens einer Signalperiode auftretenden logischen Werte des digitalen Ausgangssignals der Abtastschaltung (14) zählt.

2. Schaltungsanordnung nach Anspruch 1,
**dadurch gekennzeichnet,** daß der Absolutspannungswert-Komparator (12) folgende Komponenten aufweist:
Zwei Differenzverstärker (24,26), denen das periodische Signal an ihren nichtinvertierenden Eingängen (+) in seiner Normalphasenlage bzw. komplementär (gegenüber der Normalphasenlage invertiert) zuführbar ist,

jeweils einen, an jeweils einem invertierenden Eingang (-) der Differenzverstärker (24,26) liegenden Kreis (28,30 bzw. 32,34) zur Einstellung jeweils einer vorgegebenen Spannungsschwelle (US1 bzw. US2) für jeweils eine Halbwelle des periodischen Signals,

und eine Und-Verknüpfung (36) an den Ausgängen der Differenzverstärker (24,26).

3. Schaltungsanordnung nach Anspruch 2,- **dadurch gekennzeichnet,** daß die Spannungsschwellen-Einstell kreise (28,30 bzw. 32,34) durch jeweils eine, an jeweils einem nichtinvertierenden Eingang (+) der Differenzverstärker (24,26) angekoppelte Reihenschaltung eines Widerstandes (28 bzw. 32) und einer Stromquelle (30 bzw. 34) gebildet sind und daß jeweils der Verbindungspunkt von Widerstand (28 bzw. 32) und Stromquelle (30 bzw. 34) an jeweils einen invertierenden Eingang (-) der Differenzverstärker (24,26) angekoppelt ist.

4. Schaltungsanordnung nach Anspruch 1 und 2,**dadurch gekennzeichnet,** daß die Differenzverstärker durch jeweils ein emittergekoppeltes Transistorpaar (T3,T4 bzw. T5,T6) gebildet sind und daß die Und-Verknüpfung der Differenzverstärker-Ausgänge dadurch gebildet ist, daß jeweils eine Transistorstufe (T4,T5 bzw. T3,T6) jeweils eines unterschiedlichen Transistorpaars (T3,T4 bzw. T5,T6) einen gemeinsamen Lastwiderstand R45 bzw. R36) aufweisen.

5. Schaltungsanordnung nach Anspruch 4,- **dadurch gekennzeichnet,** daß die Werte der Lastwiderstände (R36,R45) sich wie 2:1 verhalten.

6. Schaltungsanordnung nach Anspruch 4 und 5,**dadurch gekennzeichnet,** daß die Spannungsschwellen-Einstellkreise jeweils durch eine Emitterfolgerstufe (T1,R1 bzw. T2,R2) aus einem Transistor (T1 bzw. T2) und einem Widerstand (R1 bzw. R2) in dessen Emitterzweig sowie jeweils eine dazu in Reihe liegende Stromquelle (I1 bzw. I2) gebildet sind und daß die Transistorstufen (T3,T4 bzw. T5,T6) der Transistorpaare an den Emitter jeweils des Transistors (T1 bzw. T2) der Emitterstufe (T1,R1 bzw. T2,R2) bzw. den Verbindungspunkt von Widerstand (R1 bzw. R2) und Stromquelle (I1 bzw. I2) angekoppelt sind.

# FIG1

# FIG 2

# FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,Y | EP-A-0 269 827  (BBC BROWN BOVERI AG) <br> * Zusammenfassung; Seite 4, Zeile 2 - Seite 5, Zeile 8; Figur 1 * <br> --- | 1 | G 01 R  19/165 <br> G 01 R  19/25 <br> H 03 F   3/45 |
| Y | US-A-4 625 283  (HURLEY) <br> * Spalte 4, Zeile 13 - Spalte 6, Zeile 61; Figuren 1-2 * <br> --- | 1 | |
| A | IBM TECHNICAL DISCLOSURE BULLETIN, Band 18, Nr. 1, Juni 1975, Seite 144, New York, US; H. Braquet et al.: "Zero-crossing detector" <br> * Seite 144,Zeilen 1-13; Figur * <br> --- | 2 | |
| A | DE-A-3 120 979  (TOKYO SHIBAURA DENKI K.K.) <br> * Seite 13, Zeile 14 - Seite 14, Zeile 2; figur 2 * <br> --- | 3,6 | |
| A | DE-A-2 855 168  (NIPPON ELECTRIC CO.) <br> * Seite 1, Zeile 1 - Seite 3, Zeile 8; figuren 3,6 * <br> --- | 4 | **RECHERCHIERTE SACHGEBIETE (Int. Cl.4)** |
| A | DE-A-3 119 923  (TOKYO SHIBAURA DENKI K.K.) <br> * Seite 5, Zeile 4 - Seite 12, Zeile 12; Figuren 1-6 * <br> --- | 4 | G 01 R  19/00 <br> G 01 R  21/00 <br> H 03 K   5/00 <br> H 03 F   3/00 |
| A | GB-A-2 135 847  (PHILIPS ELECTRONIC AND ASSOC. INDUSTRIES LTD) <br> * Seite 1, Zeile 46 - Seite 2, Zeile 36; Figur 1 * <br> ----- | 2,4-5 | |

Der vorliegende Recherchenbericht wurde für alle Patentansprüche erstellt

| Recherchenort | Abschlußdatum der Recherche | Prüfer |
|---|---|---|
| DEN HAAG | 19-12-1988 | TRELEVEN C. |